# EUROPEAN PATENT APPLICATION

(11) **EP 2 966 699 A1**
(43) Date of publication of application: **13.01.2016**
(21) Application number: 14761087.7
(22) Date of filing: 05.03.2014
(51) Int. Cl.: H01L 35/08, H01L 35/16, H01L 35/34

(54) **THERMOELECTRIC CONVERTER AND METHOD FOR MANUFACTURING SAME**

(30) Priority: 05.03.2013 JP 2013043089; 10.10.2013 JP 2013212413
(71) Applicant: Denso Corporation, Kariya-city Aichi 448-8661 (JP)
(72) Inventor: SHIRAISHI, Yoshihiko, Kariya-city Aichi 448-8661 (JP); SAKAIDA, Atusi, Kariya-city Aichi 448-8661 (JP); TANIGUCHI, Toshihisa, Kariya-city Aichi 448-8661 (JP); SAITOU, Keita, Kariya-city Aichi 448-8661 (JP)
(74) Representative: Kuhnen & Wacker
(86) International application number: PCT/JP2014/055635
(87) International publication number: WO 2014/136841

(57) **Abstract**

Respective thermoelectric elements (40 and 50) and respective front surface patterns (21) have an interface therebetween in which metal atoms configuring the thermoelectric elements (40 and 50) and metal atoms configuring the front surface pattern (21) are diffused to form an alloy layer (71). The respective thermoelectric elements (40 and 50) and respective back surface patterns (31) have an interface therebetween in which metal atoms configuring the thermoelectric elements (40 and 50) and metal atoms configuring the back surface pattern (31) are diffused to form an alloy layer (72). The respective thermoelectric elements (40 and 50), the respective front surface patterns (21) and the respective back surface patterns (31) are electrically and mechanically connected to each other via the alloy layers (71 and 72).

## Description

### [Technical Field]

The present invention relates to a thermoelectric converter in which thermoelectric transducers are electrically and mechanically connected to wiring patterns, and also relates to a method for producing the same.

### [Background Art]

As a thermoelectric converter of this type, one having the following configuration is proposed. In the configuration, a plurality of thermoelectric transducers are arranged between an upper circuit board and a lower circuit board, and the plurality of thermoelectric transducers are electrically and mechanically connected to wiring patterns formed on the upper and lower circuit boards via solder (e.g., see PTL 1).

Specifically, in this thermoelectric converter, each wiring pattern is formed thereon with a laminate film which is a lamination of Ni, Pd, Pt, Nb, Cr, Ti and the like. The laminate film is bonded to the solder, with a hollow space being formed between adjacent thermoelectric transducers.

With this configuration, wettability of the solder is improved by the laminate film, while achieving strong bonding between the solder and each of the wiring patterns. Further, the arrangement of the laminate film of Ni, Pd, Pt, Nb, Cr, Ti and the like between the thermoelectric transducers and the solder can achieve strong bonding between the solder and the thermoelectric transducers.

The above thermoelectric converter is produced as follows. First, thermoelectric transducers are formed by sintering or the like, followed by forming a laminate film on portions of the thermoelectric transducers which portions will be brought into contact with solder. Further, a wiring pattern is formed on each of lower and upper circuit boards, while forming a laminate film on each of the wiring patterns. Then, the thermoelectric transducers are arranged on the lower circuit board via solder, while the upper circuit board is arranged on the thermoelectric transducers via solder. After that, the resultant object is subjected to solder reflow or the like to electrically and mechanically connect the laminate films to the thermoelectric transducers via the solder, thereby producing the thermoelectric converter.

### [Citation List]

### [Patent Literature]

[PTL 1] JP-A-2003-282974

### [Summary of the Invention]

### [Technical Problem]

However, use of solder in the above thermoelectric converter involves the necessity of using laminate films to improve the wettability of the solder. This raises a problem of increasing the number of parts and complicating the structure, and also raises a problem of increasing cost.

In light of the problems set forth above, the present invention has as its object to provide a thermoelectric converter of a simple configuration which is able to electrically and mechanically (physically) connect thermoelectric transducers to a wiring pattern, and a method for producing the thermoelectric converter.

### [Solution to Problem]

In order to achieve the above object, according to an aspect of the present invention, there is provided a thermoelectric converter including: an insulating base (10) that is formed with a plurality of via holes (11 and 12) therethrough in a thickness direction; thermoelectric elements (40 and 50) that are arranged at the via holes and formed of an alloy in which a plurality of metal atoms retain a predetermined crystal structure; front surface patterns (21) that are arranged on a front surface (10a) of the insulating base and are each electrically connected to predetermined ones of the thermoelectric elements; and back surface patterns (31) that are arranged on a back surface (10b) of the insulating base and are each electrically connected to predetermined ones of the thermoelectric elements. The thermoelectric converter has the following characteristics.

Specifically, each of the thermoelectric elements and each of the front surface patterns have an interface therebetween in which metal atoms configuring the thermoelectric elements and metal atoms configuring the front surface patterns are diffused to configure an alloy layer (71); each of the thermoelectric elements and each of the back surface patterns have an interface therebetween in which metal atoms configuring the thermoelectric elements and metal atoms configuring the back surface patterns are diffused to configure an alloy layer (72); and the respective thermoelectric elements, the respective front surface patterns and the respective back surface patterns are electrically and mechanically (physically) connected to each other via the alloy layers.

With this configuration, there is no need to use solder and no need to form a laminated film which is indispensable for using solder. Further, the alloy layer formed in each of the interfaces between each thermoelectric element, and each of the front and back surface patterns is configured by the metal atoms that configure the thermoelectric elements, and the front and back surface patterns. In other words, there is no need to interpose another member in each of the interfaces between each thermoelectric element, and each of the front and back surface patterns. By reducing the number of parts in this way, the configuration can be simplified, which further leads to reduction of cost.

According to another aspect of the present invention, there is provided a production method including: a step of preparing an insulating base (10) that is configured to contain a thermoplastic resin, and formed with a plurality of via holes (11 and 12) therethrough in a thickness direction, the via holes being filled with conductive pastes (41 and 51) that are each in paste form with an addition of an organic solvent to an alloy powder in which a plurality of metal atoms retain a predetermined crystal structure; a step of forming a laminate (90) by arranging a front surface protective member (20) on a front surface (10a) of the insulating base, the front surface protective member (20) having front surface patterns (21) each contacting predetermined ones of the conductive pastes, and by arranging a back surface protective member (30) on a back surface (10b) of the insulating base, the back surface protective member (30) having back surface patterns (31) each contacting predetermined ones of the conductive pastes; and a step of integration that is performed by: applying pressure to the laminate in a lamination direction, while the laminate is heated; while forming thermoelectric elements (40 and 50) from the conductive pastes, forming an alloy layer (71) by diffusion of metal atoms configuring the thermoelectric elements and metal atoms configuring the front surface patterns, and forming an alloy layer (72) by diffusion of metal atoms configuring the thermoelectric elements and metal atoms configuring the back surface patterns; and electrically and mechanically (physically) connecting the respective thermoelectric elements, the respective front surface patterns and the respective back surface patterns to each other via the alloy layers.

According to this, alloy layers are formed in the interfaces between the thermoelectric elements, and the front and back surface patterns while the thermoelectric elements are formed. Thus, the thermoelectric elements are prevented cracking when pressure is applied.

Further, according to another aspect of the present invention, there is provided a production method including: a step of preparing an insulating base (10) that is configured to contain a thermoplastic resin, formed with a plurality of via holes (11 and 12) therethrough in a thickness direction, and embedded with thermoelectric elements (40 and 50) in the via holes; a step of forming a laminate (90) by arranging a front surface protective member (20) on a front surface (10a) of the insulating base, the front surface protective member (20) having front surface patterns (21) each contacting predetermined ones of the thermoelectric elements, and by arranging a back surface protective member (30) on a back surface (10b) of the insulating base, the back surface protective member (30) has back surface patterns (31) each contacting predetermined ones of the thermoelectric elements; and a step of integration performed by applying pressure to the laminate in a lamination direction while the laminate is heated, forming an alloy layer (71) that is configured by diffusion of metal atoms configuring the thermoelectric elements and metal atoms configuring the front surface patterns, while forming an alloy layer (72) by diffusion of metal atoms configuring the thermoelectric elements and metal atoms configuring the back surface patterns, and electrically and mechanically (physically) connecting the respective thermoelectric elements, the respective front surface patterns and the respective back surface patterns to each other via the alloy layers.

According to this, the thermoelectric elements are embedded in the respective via holes formed in the insulating base. At the step of integration, such an insulating base can cancel the stress components in a direction perpendicular to the lamination direction, from among the stress components generated in the thermoelectric elements. Accordingly, the thermoelectric elements can be prevented from being cracked in a direction perpendicular to the lamination direction.

Further, as an example, prior to the step of forming the laminate, the insulating base is formed with through holes (air spaces) (13); and, at the step of integration, the thermoelectric elements and the alloy layers can be formed, while the thermoplastic resin is fluidized and flows into the air spaces.

According to still another example, at the step of forming the laminate, members that contain a thermoplastic resin are used as the front surface protective member and the back surface protective member; and at the step of integration, the laminate is applied with pressure using a pair of pressing plates (100) that are formed with recesses (100a) in at least either of those portions which face a front surface of the insulating base and those portions which face a back surface of the insulating base, at least one of thermoplastic resins configuring the front surface protective member and the back surface protective member is fluidized and flowed into the recesses, and the thermoelectric elements and the alloy layers are formed while the thermoplastic resin configuring the insulating base is fluidized.

According to the configurations related to these examples, at the step of integration, the pressure applied to the conductive pastes can be increased, and thus the alloy layers can be easily formed between the thermoelectric elements, and the front and back surface patterns.

It should be noted that the bracketed references of the means described in this section and in the claims show correspondence with specific means described in the embodiments set forth below.

### [Brief Description of the Drawings]

In the accompanying drawings:
Fig. 1 is a plan view illustrating a thermoelectric converter in a first embodiment of the present invention;
Fig. 2 is a cross-sectional view taken along the line II-II of Fig. 1;
Fig. 3 is a cross-sectional view taken along the line III-III of Fig. 1;
Fig. 4 is an enlarged view illustrating the region A enclosed by the dash-dot-dot line of Fig. 2;
Fig. 5 shows cross-sectional views illustrating a process of producing the thermoelectric converter illustrated in Fig. 1;
Fig. 6 is a diagram illustrating conditions of production at a step of integration illustrated in Fig. 5 by (h);
Fig. 7 is a cross-sectional view illustrating a thermoelectric converter in a second embodiment of the present invention;

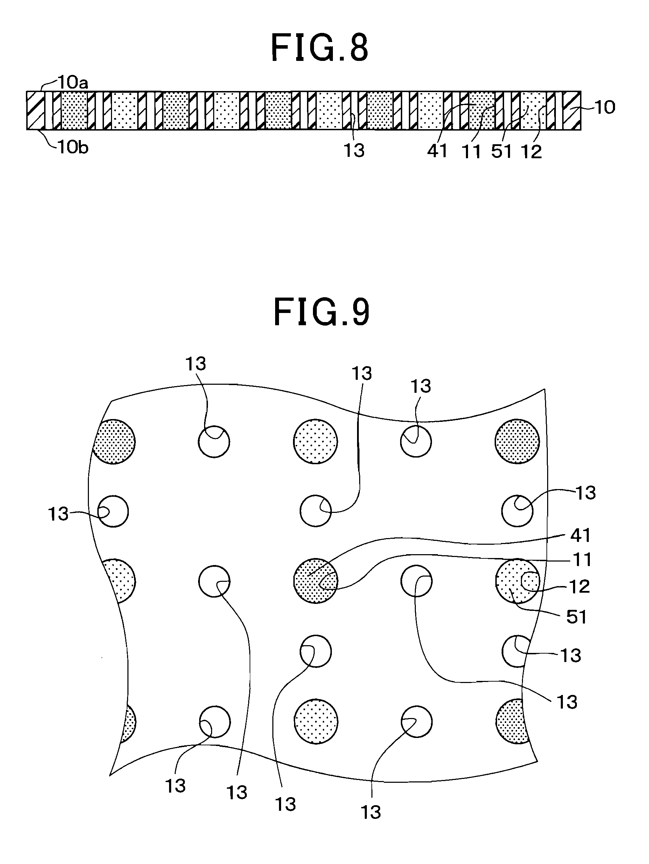

Fig. 8 is a cross-sectional view illustrating a step performed after the step illustrated in Fig. 5 by (d), in a third embodiment of the present invention;
Fig. 9 is a surface view illustrating the insulating base illustrated in Fig. 8;
Fig. 10 is a cross-sectional view illustrating the details in performing the step illustrated in Fig. 5 by (h) using the insulating base illustrated in Fig. 8;
Fig. 11 is a cross-sectional view illustrating the details in performing the step illustrated in Fig. 5 by (h), in a fourth embodiment of the present invention;
Fig. 12 is a cross-sectional view illustrating a process of producing a thermoelectric converter in a fifth embodiment of the present invention; and
Fig. 13 is a diagram illustrating conditions of production at the step of integration illustrated in Fig. 12 by (f).

### [Description of Embodiments]

With reference to the drawings, hereinafter are described some embodiments of the present invention. It should be noted that, in the following description, the components identical or equivalent between the embodiments are given the same reference numerals.

### (First Embodiment)

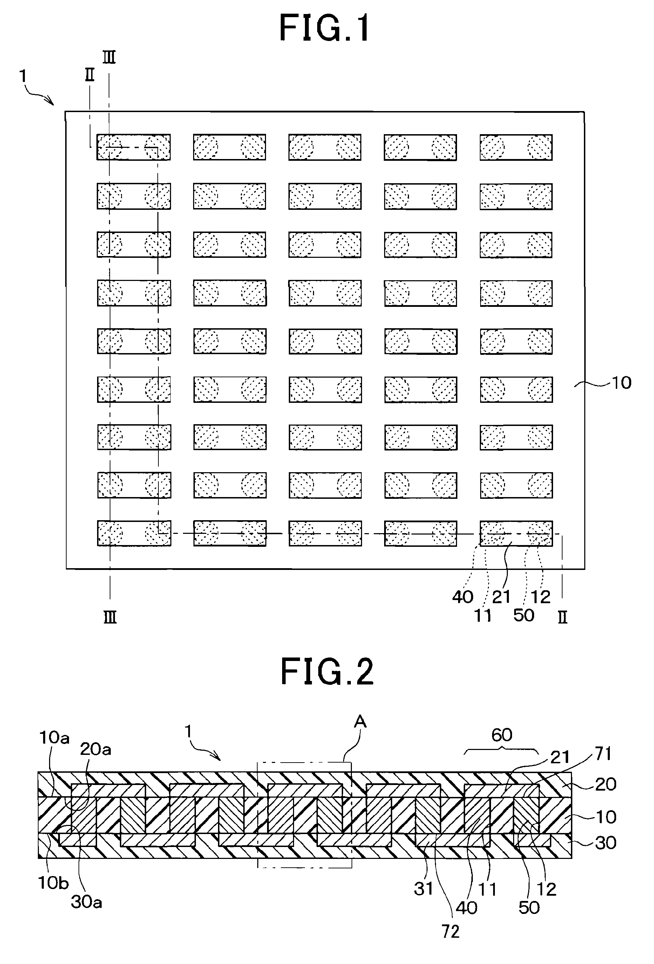

Referring to the drawings, a first embodiment of the present invention will be described. As shown in Figs. 1 to 3, a thermoelectric converter 1 of the present embodiment is configured to include an integrated body of an insulating base 10, a front surface protective member 20, and a back surface protective member 30. Inside the integrated body, first and second interlayer connection members 40 and 50 made of different metal materials are alternately connected in series.

In Fig. 1, for the sake of clarity, the front surface protective member 20 is omitted. Although Fig. 1 is not a cross-sectional view, the first and second interlayer connection members 40 and 50 are hatched. In the present embodiment, the first and second interlayer connection members 40 and 50 correspond to the thermoelectric transducers of the present invention.

The insulating base 10 is configured, in the present embodiment, by a flat rectangular thermoplastic resin film that contains polyether ether ketone (PEEK) or polyetherimide (PEI). The insulating base 10 includes a plurality of first and second via holes 11 and 12 which are alternately formed through the insulating base 10 in a thickness direction so as to form a zigzag pattern.

In the present embodiment, the first and second via holes 11 and 12 each have a constant diameter from a front surface 10a toward a back surface 10b, forming a cylindrical shape. As an alternative to this, the first and second via holes 11 and 12 may each have a tapered shape in which the diameter is reduced from the front surface 10a toward the back surface 10b, or may have a polygonal cylindrical shape.

Thus, the first interlayer connection members 40 are arranged in the respective first via holes 11, while the second interlayer members 50 made of a metal material different from that of the first interlayer connection member 40 are arranged in the respective second via holes 12. In other words, the first and second interlayer connection members 40 and 50 are alternately arranged in the insulating base 10.

The first interlayer connection members 40 are configured, but are not particularly limited to, by a conductive paste that contains a Bi-Sb-Te alloy powder (metal particles) configuring a P type layer. The second interlayer connection members 50 are configured by a conductive paste that contains a Bi-Te alloy powder (metal particles) configuring an N type material.

The front surface protective member 20, which is formed of a flat rectangular thermoplastic resin film that contains polyether ether ketone (PEEK) or polyetherimide (PEI), is arranged on the front surface 10a of the insulating base 10. In a plan view, the front surface protective member 20 has a shape and size which are the same as those of the insulating base 10. The front surface protective member 20 has a surface 20a opposed to the insulating base 10. The surface 20a is provided thereon with a copper foil or the like which is patterned into a plurality of front surface patterns 21 that are spaced apart from each other. The front surface patterns 21 are electrically connected, as appropriate, to the respective first and second interlayer connection members 40 and 50.

Specifically, when one first interlayer connection member 40 and one second interlayer connection member 50 which are adjacent to each other are taken as a set 60, the first and second interlayer connection members 40 and 50 in each set 60 are connected to the same single front surface pattern 21. In other words, the first and second interlayer connection members 40 and 50 in each set 60 are electrically connected to each other via the front surface pattern 21. In the present embodiment, one first interlayer connection member 40 and one second interlayer connection member 50 which are adjacent to each other along a long-side direction of the insulating base 10 (right-and-left direction in Fig. 1) are taken as the set 60.

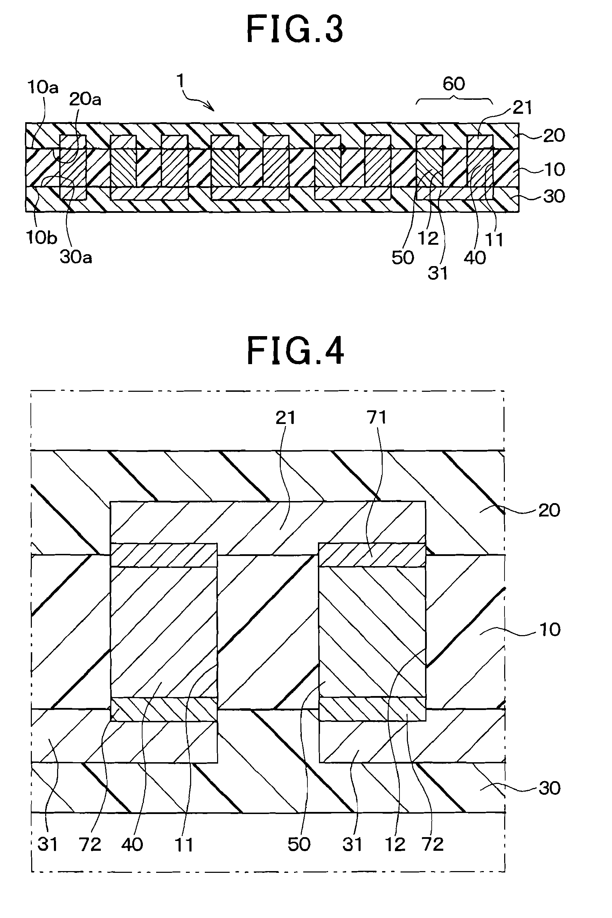

The following description sets forth a connection structure between the first and second interlayer connection members 40 and 50, and the front surface patterns 21. As shown in Fig. 4, a Cu-Te based alloy layer 71 is formed in an interface of (between) each of the first and second interlayer connection members 40 and 50 and each front surface pattern 21. The Cu-Te based alloy layer 71 is configured in the interface by diffusion of metal atoms (Te) contained in the first and second interlayer connection members 40 and 50, and metal atoms (Cu) contained in the front surface pattern 21. The first and second interlayer connection members 40 and 50 are electrically and mechanically (physically) connected to the front surface pattern 21 via the alloy layer 71.

The alloy layer 71 herein is configured by a Cu-Te based alloy. Alternatively, for example, the alloy layer 71 may be configured by a Cu-Bi based alloy, depending on the formulation ratio or the like of the alloy powders configuring the first and second interlayer connection members 40 and 50.

The back surface protective member 30, which is formed of a flat rectangular thermoplastic resin film that contains polyether ether ketone (PEEK) or polyetherimide (PEI), is arranged on the back surface 10b of the insulating base 10. The back surface protective member 30 has a shape and size which are the same as those of the insulating base 10. The back surface protective member 30 has a surface 30a opposed to the insulating base 10. The surface 30a is provided thereon with a copper foil or the like which is patterned into a plurality of surface patterns 31 that are spaced apart from each other. The surface patterns 31 are electrically connected, as appropriate, to the respective first and second interlayer connection members 40 and 50.

Specifically, in adjacently located sets 60, the first interlayer connection member 40 in one set 60 and the second interlayer connection member 50 in the other set 60 are connected to the same single back surface pattern 31. In other words, the first and second interlayer members 40 and 50 are electrically connected to each other via the back surface pattern 31 bridging over the sets 60.

In the present embodiment, as shown in Fig. 2, the two sets 60 juxtaposed along a long-side direction of the insulating base 10 (right-and-left direction in Fig. 1) are basically taken as the sets 60 adjacent to each other. Further, as shown in Fig. 3, on an outer edge of the insulating base 10, the two sets 60 juxtaposed along a short-side direction (top-and-bottom direction in Fig. 1) are taken as the sets 60 adjacent to each other.

Accordingly, the first and second connection members 40 and 50 are serially connected in a long-side direction of the insulating base 10 in an alternate manner, turned around, and returned to the alternate serial connection in a long-side direction. In other words, the first and second interlayer connection members 40 and 50 are alternately connected in series in a polygonal line shape.

The following description sets forth a connection structure between the first and second interlayer connection members 40 and 50, and the back surface patterns 31. As shown in Fig. 4, a Cu-Te based alloy layer 72 is formed in an interface of (between) each of the first and second interlayer connection members 40 and 50 and each back surface pattern 31, as in an interface of (between) each of the first and second interlayer connection members 40 and 50 and each front surface pattern 21. The Cu-Te based alloy layer 72 is configured in the interface by diffusion of metal atoms (Te) contained in the first and second interlayer connection members 40 and 50, and metal atoms (Cu) contained in the back surface pattern 31. The first and second interlayer connection members 40 and 50 are electrically and mechanically (physically) connected to the back surface pattern 31 via the alloy layer 72.

The alloy layer 72 herein is configured by a Cu-Te based alloy. Alternatively, for example, the alloy layer 72 may be configured by a Cu-Bi based alloy, depending on the formulation ratio or the like of the alloy powders configuring the first and second interlayer connection members 40 and 50.

In another cross section besides the ones shown in Figs. 2 and 3, the back surface protective member 30 is formed with interlayer connection members which are electrically connected to the respective back surface patterns 31 and exposed from one surface of the back surface protective member 30, the one surface being on the opposite side of the insulating base 10. The back surface patterns 31 are ensured to establish an electrical connection with the outside via these interlayer connection members.

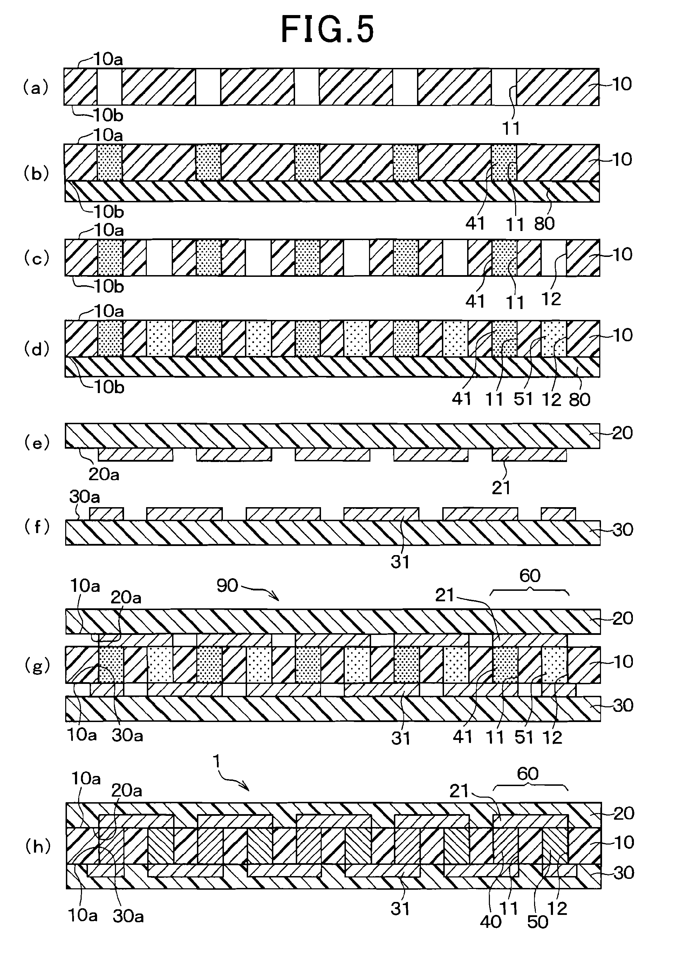

So far, a basic configuration of the thermoelectric converter 1 of the present embodiment has been described. Referring now to Fig. 5, a method for producing the thermoelectric converter 1 is described.

Fig. 5 shows diagrams each taken along the line II-II of Fig. 1.

First, as shown in Fig. 5 by (a), the insulating base 10 is made ready and the plurality of first via holes 11 are formed by drilling or the like.

Then, as shown in Fig. 5 by (b), a first conductive paste 41 is filled in the first via holes 11.

The method (device) that can be used for filling the first conductive paste 41 in the first via holes 11 may be the method (device) described in JP-A-2010-050356 filed by the present applicant.

Roughly explained, the insulating base 10 is placed on a holder support, not shown, via absorption paper 80 such that the back surface 10b faces the absorption paper 80. The absorption paper 80 only needs to be a material that can absorb an organic solvent of the first conductive paste 41, and thus may be generally used good quality paper or the like. While being molten, the first conductive paste 41 is filled in the first via holes 11. Thus, most of the organic solvent of the first conductive paste 41 is absorbed by the absorption paper 80. As a result, the alloy powder is located in the first via holes 11 in an intimate manner.

The first conductive paste 41 used in the present embodiment is an alloy powder in paste form in which the metal atoms retain a given crystal structure, with an addition of an organic solvent, such as paraffin, having a melting point of 43°C. Therefore, in filling the first conductive paste 41 in the first via holes 11, the front surface 10a of the insulating base 10 is heated to about 43°C. The alloy powder configuring the first conductive paste 41 that can be used includes, for example, a Bi-Sb-Te alloy or the like formed by mechanical alloying.

Then, as shown in Fig. 5 by (c), the plurality second via holes 12 are formed in the insulating base 10 by drilling or the like. As mentioned above, the second via holes 12 are formed so as to be alternated with the first via holes 11 and to configure the zigzag pattern together with the first via holes 11.

Then, as shown in Fig. 5 by (d), the insulating base 10 is again placed on the holder support, not shown, via the absorption paper 80 such that the back surface 10b faces the absorption paper 80. Then, similar to the manner of filling the first conductive paste 41, a second conductive paste 51 is filled in the second via holes 12. Thus, most of the organic solvent in the second conductive paste 51 is absorbed by the absorption paper 80. As a result, the alloy powder is located in the second via holes 12 in an intimate manner.

The second conductive paste 51 used in the present embodiment is an alloy powder in paste form in which the metal atoms different from those configuring the first conductive paste 41 retain a given crystal structure, with an addition of an organic solvent, such as terpene, having a melting point at room temperature. In other words, the organic solvent that can be used for configuring the second conductive paste 51 is one having a melting point lower than that of the organic solvent configuring the first conductive paste 41. Then, in filling second conductive paste 51 in the second via holes 12, the front surface 10a of the insulating base 10 is kept at normal temperature. In other words, the second conductive paste 51 is filled in the second via holes 12 in a state where the organic solvent contained in the first conductive paste 41 is solidified. Thus, the second conductive paste 51 is prevented from entering the first via holes 11.

The alloy powder that can be used for configuring the second conductive paste 51 is a Bi-Te based powder or the like formed, for example, by mechanical alloying.

Through the steps as described above, the insulating base 10 is prepared, with the first and second conductive pastes 41 and 51 being filled in.

The front surface protective member 20 and the back surface protective member 30 have the surfaces 20a and 30a, respectively, facing the insulating base 10. As shown in Fig. 5 by (e) and (f), each of the surfaces 20a and 30a is formed with a copper foil or the like thereon through steps different from the steps described above. Each of the copper foils is appropriately patterned to prepare the front surface protective member 20 on which the plurality of front surface patterns 21 are formed, being spaced apart from each other, and the back surface protective member 30 on which the plurality of back surface patterns 31 are formed, being spaced apart from each other.

After that, as shown in Fig. 5 by (g), the back surface protective member 30, the insulating base 10, and the front surface protective member 20 are laminated in this order to configure a laminate 90. Specifically, the first conductive paste 41 filled in one first via hole 11 and the second conductive paste 51 filled in one adjacently located second via hole 12 are taken as the set 60. Taking the set 60 accordingly, the front surface protective member 20 is arranged such that, on the front surface side 10a of the insulating base 10, the first and second conductive pasts 41 and 51 of each set 60 are in contact with the same single front surface pattern 21. In the present embodiment, as mentioned above, the first conductive paste 41 filled in one first via hole 11 and the second conductive paste 51 filled in one second via hole 12, which are adjacently located along a long-side direction of the insulating base 10 (right-and-left direction in Fig. 1) are taken as the set 60.

Further, the back surface protective member 30 is arranged such that, on the back surface 10b side of the insulating base 10, the first conductive paste 41 in one set 60 out of adjacently located sets 60 and the second conductive paste 51 in the other set 60 are in contact with the same single back surface pattern 31. In the present embodiment, as mentioned above, two sets 60 juxtaposed along a long-side direction of the insulating base 10 (right-and-left direction in Fig. 1) are taken as adjacently located sets 60. Further, on an outer edge of the insulating base 10, two sets 60 juxtaposed along a short-side direction of the insulating base 10 are taken as adjacently located sets 60.

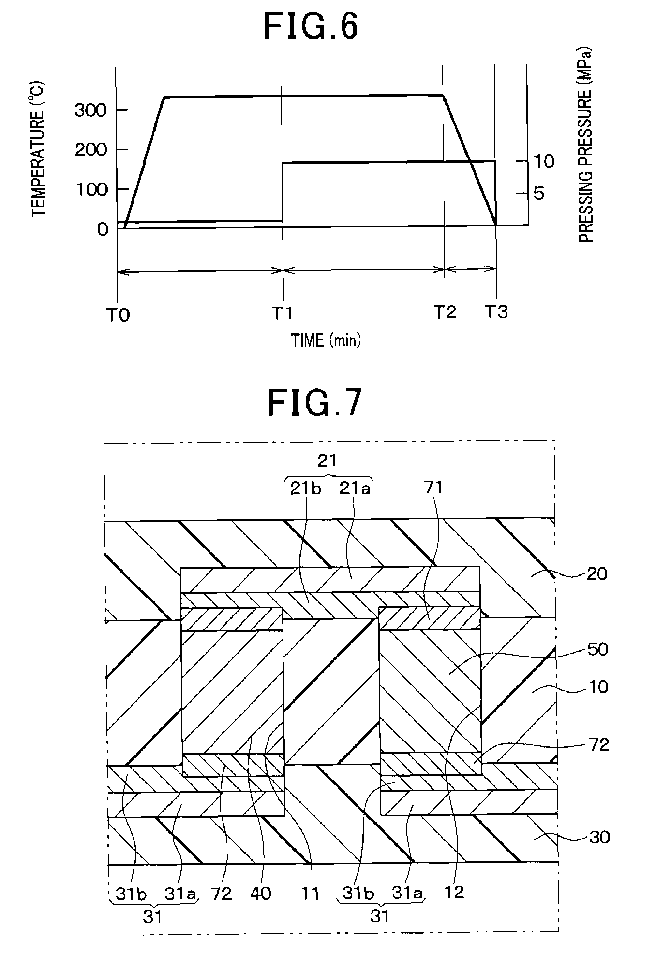

Subsequently, as shown in Fig. 5 by (h), the laminate 90 is placed between a pair of pressing plates, not shown, and pressed in a vacuum from both upper and lower surfaces in a lamination direction, while being heated, thereby obtaining an integral body of the laminate 90. Although not particularly limited to this, in obtaining the integral body of the laminate 90, a cushioning material, such as rock wool paper, may be arranged between the laminate 90 and each of the pressing plates. Referring to Fig. 6, the step of integration of the present embodiment is described in detail.

As shown in Fig. 6, at the step of integration, the laminate 90 is applied, first, with a pressure of 0.1 Mpa until time point T1, while been heated to some 320°C to evaporate the organic solvents contained in the first and second conductive pastes 41 and 51.

It should be noted that the interval between T0 to T1 corresponds to about 10 minutes. The organic solvents contained in the first and second conductive pastes 41 and 51 are the ones that have remained without being absorbed by the absorption paper 80 at the steps shown in Fig. 5 by (b) and (d).

Then, the laminate 90 is applied with a pressure of 10 MPa until time point T2, with the temperature being retained around 320°C that is the temperature equal to or more than the softening point of a thermoplastic resin. In this case, the thermoplastic resin configuring the insulating base 10 is fluidized to apply pressure to the first and second conductive pastes 41 and 51 (alloy powders). Thus, the alloy powders are mutually pressure-welded and solid-phase sintered to thereby configure the first and second interlayer connection members 40 and 50. In other words, the first and second interlayer connection members 40 and 50 are each configured by a sintered alloy in which a plurality of metal atoms (alloy powder) retain a crystal structure of the metal atoms. Further, the alloy powders are also pressure-welded to the front surface pattern 21 and the back surface pattern 31, respectively, to diffuse the metal atoms configuring the first and second interlayer connection members 40 and 50 and the metal atoms configuring the front surface pattern 21 or the back surface pattern 31. Specifically, the metal atoms are diffused into the interface between the first interlayer connection member 40 and the front surface pattern 21, and the interface between the second interlayer connection member 50 and the back surface pattern 31, thereby forming the alloy layers 71 and 72, respectively. As a result, the first and second interlayer connection members 40 and 50 are electrically and mechanically (physically) connected to the front surface pattern 21 and the back surface pattern 31, respectively, via the alloy layers 71 and 72.

It should be noted that the interval between T1 and T2 is about 10 minutes. In the present embodiment, a Bi-Sb-Te based powder is used as the alloy powder contained in the first conductive paste 41, and a Bi-Te based powder is used as the alloy powder contained in the second conductive paste 51. Since the melting point of each of these alloy powders is higher than 320°C, the alloy powders contained in the first and second conductive pastes 41 and 51 are not melted at this step.

After that, the resultant object is cooled until time point T3 while the pressure is retained at 10 MPa. As a result, an integral body of the laminate 90 is obtained, thereby producing the thermoelectric converter 1 shown in Fig. 1.

It should be noted that the interval between T2 and T3 is about eight minutes. Further, the metallic materials configuring the front and back surface patterns 21 and 31, the first and second interlayer connection members 40 and 50, and the alloy layers 71 and 72 have a linear expansion coefficient smaller than that of the thermoplastic resins configuring the insulating base 10, and the front and back surface protective members 20 and 30. Accordingly, expansion and contraction of the metallic materials configuring the front and back surface patterns 21 and 31, the first and second interlayer connection members 40 and 50, and the alloy layers 71 and 72 are smaller than those of the thermoplastic resins configuring the insulating base 10, and the front and back surface protective members 20 and 30. In the thermoelectric converter 1 produced in this way, a stress is applied from the thermoplastic resins configuring the insulating base 10, and the front and back surface protective members 20 and 30, to the front and back surface patterns 21 and 31, the first and second interlayer connection members 40 and 50, and the alloy layers 71 and 72. In other words, the thermoelectric converter 1 is produced, retaining a strong connection of the first and second interlayer connection members 40 and 50 relative to the alloy layers 71 and 72, and a strong connection of the front and back surface patterns 21 and 31 relative to the alloy layers 71 and 72, respectively.

As described above, in the thermoelectric converter 1 of the present embodiment, the first and second interlayer connection members 40 and 50 are electrically and mechanically (physically) connected to the front and back surface patterns 21 and 31 via the alloy layers 71 and 72, respectively. Thus, there is no need to use solder and no need to form a laminate film which is indispensable for using solder. Further, the alloy layers 71 and 72 formed in interfaces between the first and second interlayer connection member 40 and 50, and the front and back surface patterns 21 and 31 are configured by the metal atoms that configure the first and second interlayer connection members 40 and 50 and the front and back surface patterns 21 and 31. In other words, there is no need to interpose another member in each of the interfaces between the first and second interlayer connection members 40 and 50, and the front and back surface patterns 21 and 31. By reducing the number of parts in this way, the configuration can be simplified, which further leads to reduction of cost.

Further, the first and second conductive pastes 41 and 51 are applied with pressure, while being heated to thereby form the first and second interlayer connection members 40 and 50. At the same time, the alloy layers 71 and 72 are formed in the respective interfaces between the first and second interlayer connection members 40 and 50, and the front and back surface patterns 21 and 31. Thus, in applying pressure, the first and second interlayer connection members 40 and 50 are prevented from being cracked.

The alloy layers 71 and 72 are formed concurrently with the formation of the first and second interlayer connection members 40 and 50 from the first and second conductive pastes 41 and 51, respectively. Therefore, there is no need to separately provide a step of forming the alloy layers 71 and 72, and thus the number of steps of production is not increased.

The present embodiment has been described by way of an example in which a Bi-Sb-Te based alloy powder is used as the first conductive paste 41, and a Bi-Te based alloy powder is used as the second conductive paste 51. However, alloy powders are not limited to these. For example, the alloy powders configuring the first and second conductive pastes 41 and 51 may be appropriately selected from alloys that are obtained by alloying copper, constantan, chromel, alumel, and the like, with iron, nickel, chrome, copper, silicon, and the like. Alternatively, the alloy powders may be appropriately selected from alloys of tellurium, bismuth, antimony or selenium, or alloys of silicon, iron or aluminum.

### (Second Embodiment)

Hereinafter is described a second embodiment of the present invention. In contrast to the first embodiment, in the present embodiment, a plating film is formed on each of the front surface pattern 21 and the back surface pattern 31. The rest of the configuration, which is similar to the first embodiment, is omitted from description.

As shown in Fig. 7, the front surface patter 21 is configured by a ground wiring 21a and a plating film 21b that is formed on the ground wiring 21a. Further, the back surface pattern 31 is configured by a ground wiring 31a and a plating film 31b formed on the ground wiring 31a. In the present embodiment, the plating films 21b and 31b are configured by Ni.

Furthermore, in the interfaces between the first and second interlayer connection members 40 and 50, and the plating films 21b and 31b, the metal atoms (Te) of the first and second interlayer connection members 40 and 50 and the metal atoms (Ni) of the plating films 21b and 31b are diffused to thereby configure the alloy layers 71 and 72 of a Ni-Te based alloy. The first and second interlayer connection members 40 and 50 are electrically and mechanically (physically) connected to the front surface pattern 21 or the back surface pattern 31 via the alloy layers 71 and 72.

Fig. 7 is an enlarged view of the region A indicated in Fig. 2. The alloy layers 71 and 72 herein are configured by the Ni-Te based alloy. Alternative to this, for example, the alloy layers 71 and 72 may be configured by a Ni-Bi based alloy, depending on the formulation ratio, for example, of the alloy powders configuring the first and second interlayer connection members 40 and 50.

According to this, the plating film 31b can determine the structure of the alloy layers 71 and 72. Thus, for example, materials that can be used as the ground wirings 21a and 31a may include materials that are unlikely to be diffused or materials that are excessively diffused relative to the first and second interlayer connection members 40 and 50, thereby improving design degree of freedom.

### (Third Embodiment)

Hereinafter is described a third embodiment of the present invention. In contrast to the first embodiment, in the present embodiment, an integral body of the laminate 90 is obtained after forming air spaces in the insulating base 10. The rest of the configuration, which is similar to the first embodiment, is omitted from description.

As shown in Fits. 8 and 9, in the present embodiment, the step shown in Fig. 5 by (d) is followed by forming through holes 13 in the insulating base 10 by means of a drill, laser, or the like, the through holes corresponding to the air spaces of the present invention. In the present embodiment, a plurality of the through holes 13 in a cylindrical shape are formed centering on each of the center of the first and second via holes 11 and 12, being evenly spaced apart in a circumferential direction on a concentric circle.

The through holes 13 herein each have a cylindrical shape. However, the through holes 13 may each have a tapered shape in which the diameter is reduced from the front surface 10a toward the back surface 10b, or may have a polygonal cylindrical shape.

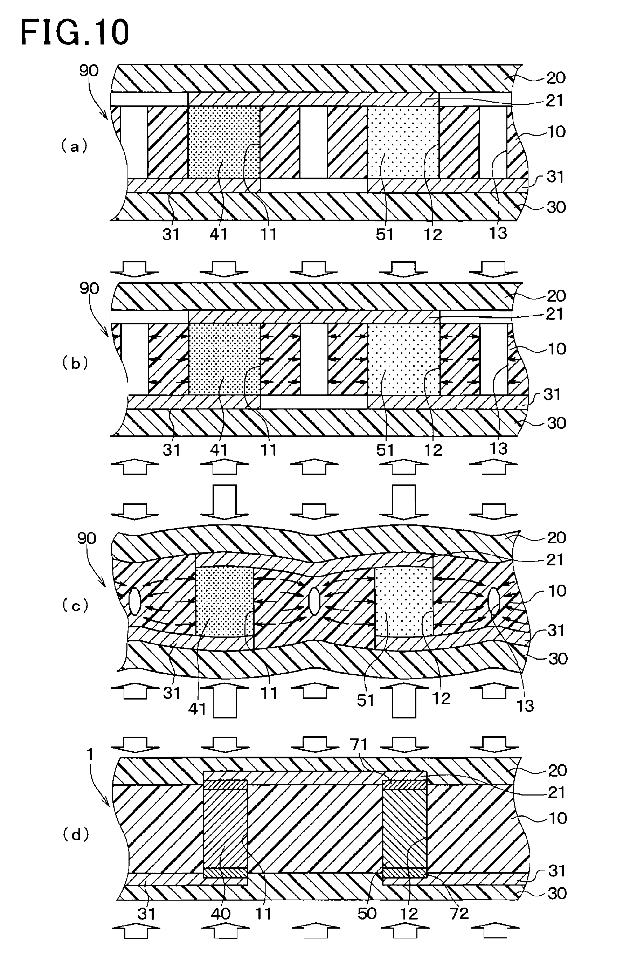

After that, the step shown in Fig. 5 by (h) is conducted to form the first and second interlayer connection members 40 and 50. Specifically, first, as shown in Fig. 10 by (a), the laminate 90 is configured. Then, as shown in Fig. 10 by (b), pressure is applied to the insulating base 10 from the front surface 10a and the back surface 10b. In this case, the thermoplastic resin configuring the insulating base 10 is fluidized and the fluidized thermoplastic resin applies pressure to the first and second conductive pastes 41 and 51 (alloy powders), while flowing into the through holes 13. Then, as shown in Fig. 10 by (c), the thermoplastic resin flows into the through holes 13 (moves in a fluidized manner), and therefore, the pressure applied to these portions (peripheries of the first and second via holes 11 and 12) is reduced. As a result, the pressure that should be originally applied to these portions is applied to the first and second conductive pastes 41 and 51. In other words, the pressure applied to the first and second conductive pastes 41 and 51 from the pressing plates can be increased. Then, as shown in Fig. 10 by (d), the first and second interlayer connection members 40 and 50 are configured, and at the same time, the alloy layers 71 and 72 are formed between the first and second interlayer connection members 40 and 50, and the front and back surface patterns 21 and 31.

As described above, in the present embodiment, the through holes 13 are formed in the insulating base 10. The first and second interlayer connection members 40 and 50 are formed while the thermoplastic resin is fluidized and flows into the through holes 13. Accordingly, the pressure applied to the first and second conductive pastes 41 and 51 can be increased, and thus the first and second conductive pastes 41 and 51 are prevented from not being solid-phase sintered. Further, since the pressure applied to the first and second conductive pastes 41 and 51 can be increased, the alloy layers 71 and 72 can be easily formed between the first and second interlayer connection members 40 and 50, and the front and back surface patterns 21 and 31.

In the present embodiment, the through holes 13 are formed on a concentric circle centering on each of the first and second via holes 11 and 12 so as to be evenly spaced apart from each other in a circumferential direction. Accordingly, in forming the first and second interlayer connection members 40 and 50, the thermoplastic resin around the first and second via holes 11 and 12 is easily fluidized and flows into the through holes 13 in an isotropic manner. Thus, the first and second via holes 11 and 12 are prevented from being displaced in a planar direction of the insulating base 10.

### (Fourth Embodiment)

Hereinafter is described a fourth embodiment. In contrast to the third embodiment, in the present embodiment, air spaces are formed between the laminate 90 and each of the pressing plates. The rest of the configuration, which is similar to the third embodiment, is omitted from description.

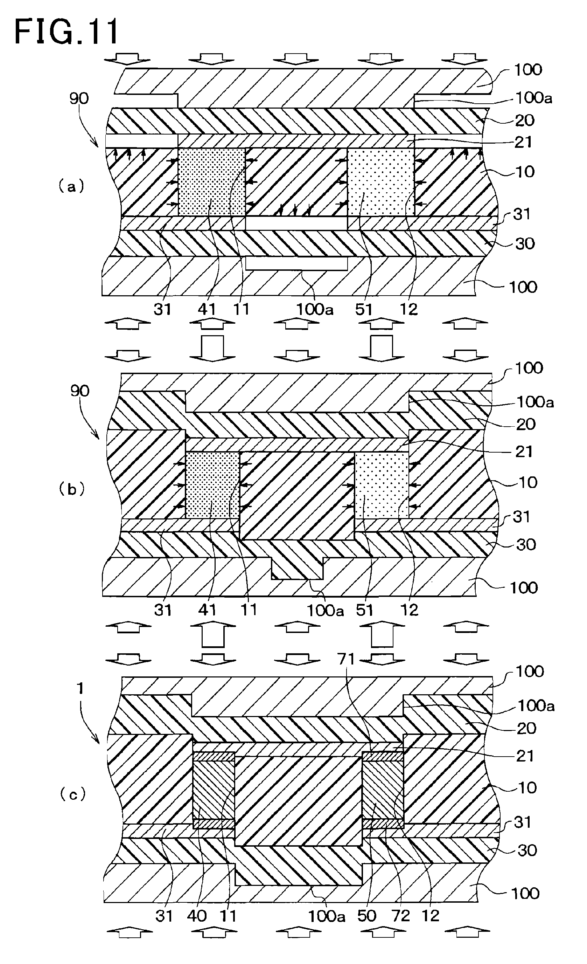

As shown in Fig. 11 by (a), in the present embodiment, no through holes 13 are formed in the insulating base 10. Pressure is applied to the laminate 90 using a pair of pressing plates 100 in each of which recesses 100a are each formed in a portion different from the portion facing the front and back surface patterns 21 and 31.

Thus, as shown in Fig. 11 by (b), the thermoplastic resin configuring the front and back surface protective members 20 and 30 is fluidized and flows into each recess 100a of the pair of pressing plates 100. At the same time, the thermoplastic resin of the insulating base 10 is fluidized and flows into the portions into which the thermoplastic resin of the protective members has flowed. Accordingly, the pressure applied to the first and second conductive pastes 41 and 51 from the pressing plates 100 is increased.

Thus, as shown in Fig. 11 by (c), the first and second interlayer connection members 40 and 50 are formed from the first and second conductive pastes 41 and 51. At the same time, the alloy layers 71 and 72 are formed between the first and second interlayer connection member 40 and 50, and the front and back surface patterns 21 and 31.

In this way, an integral body of the laminate 90 is ensured to be obtained using a pair of pressing plates 100 in each of which the recesses 100a are formed. With this configuration as well, the thermoplastic resin configuring the insulating base 10 is fluidized to thereby increase the pressure applied to the first and second conductive pastes 41 and 51. Accordingly, the advantageous effects similar to those of the third embodiment can be obtained.

In the thermoelectric converter 1 produced in the present embodiment, projections are formed by the thermoplastic resin flowed into the recesses 100a. Thus, after obtaining the integral body of the laminate 90, the projections may be ensured to be removed such as by cutting, or the projections may be covered with a thermally conductive sheet or the like to flatten both the upper and lower surfaces of the thermoelectric converter 1.

The description herein has been provided by way of an example in which the recesses 100a are formed in each of the pair of pressing plates 100. Alternatively to this, the pair of pressing plates 100 to be used may be formed with the recesses 100a in only one of the plates.

Further, the present embodiment has been described by way of an example in which the pair of pressing plates 100 in use are formed with the recesses 100a each of which is in a portion different from the portion facing the front and back surface patterns 21 and 31. However, the pair of pressing plates 100 to be used may be formed with the recesses 100a each of which is in a portion that includes the portion facing the front and back surface patterns 21 and 31. Use of such pressing plates 100 can also fluidize the thermoplastic resins configuring the insulating base 10, and the front and back surface protective members 20 and 30. Accordingly, similar advantageous effects can be obtained.

### (Fifth Embodiment)

Hereinafter is described a fifth embodiment of the present invention. In the present embodiment, the production method has been changed in contrast to the first embodiment. The rest of the configuration, which is similar to the first embodiment, is omitted from description.

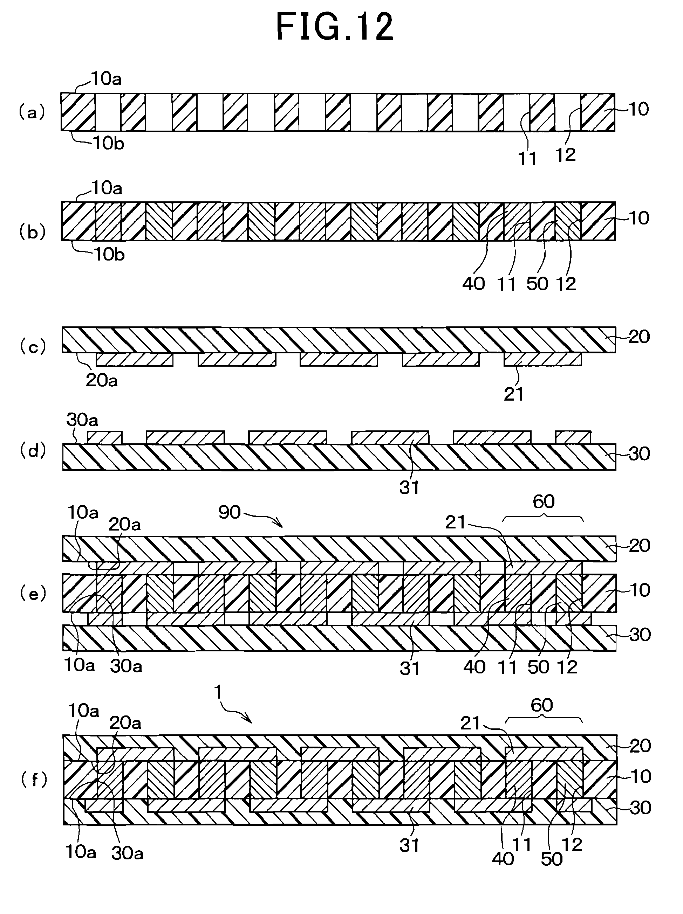

As shown in Fig. 12 by (a), first and second via holes 11 and 12 are formed first in the insulating base 10. Then, as shown in Fig. 12 by (b), first and second interlayer connection members 40 and 50 are embedded in the first and second via holes 11 and 12, respectively.

The first and second interlayer connection members 40 and 50 are configured by solid-phase sintering a Bi-Sb-Te alloy powder (metallic particles) or a Bi-Te alloy powder (metallic particles), followed by, for example, appropriately cutting the resultant object.

Further as shown in Fig. 12 by (c) and (d), there are prepared a front surface protective member 20 formed with a plurality of front surface patterns 21 and a back surface protective member 30 formed with a plurality of back surface pattern 31, similar to the ones shown in Fig. 5 by (e) and (f).

Then, as shown in Fig. 12 by (e), the back surface protective layer 30, the insulating base 10 and the front surface protective member 20 are laminated in this order to configure a laminate 90.

Then, as shown in Fig. 12 by (f), the laminate 90 is placed between a pair of pressing plates, not shown, and applied with a pressure, while being heated in a vacuum from both the upper and lower surfaces thereof in a lamination direction, thereby obtaining an integral body of the laminate 90.

Since the first and second interlayer connection members 40 and 50 are already arranged in the insulating base 10, the above step of integration only has to be conducted under the conditions for forming alloy layers 71 and 72. Thus, compared to the step shown in Fig. 5 by (h), the above step of integration can be conducted with a lower pressure.

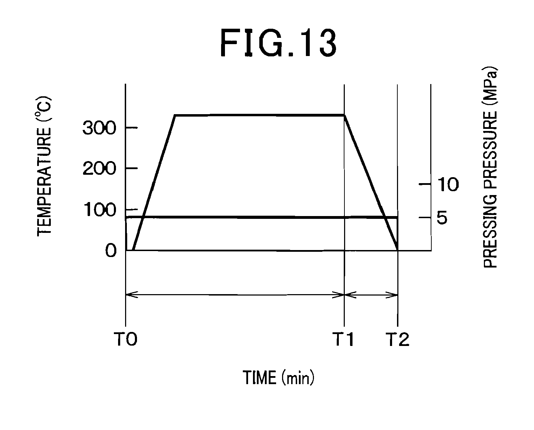

Specifically, as shown in Fig. 13, the laminate 90 is applied with a pressure of 5 Mpa until time point T1, while being heated to some 320°C. In this case, the thermoplastic resins configuring the insulating base 10, and the front and back surface protective members 20 and 30 are fluidized, however, the first and second interlayer connection members 40 and 50 that are embedded in the first and second via holes 11 and 12, respectively, are not fluidized because they are already solidified. Therefore, the pressure applied to the peripheries of the first and second via holes 11 and 12 is reduced. This means that the pressure that should originally be applied to these peripheries is applied to the first and second interlayer connection members 40 and 50 (between the first and second interlayer connection portions 40 and 50, and the front and back surface patterns 21 and 31). Accordingly, compared to the first embodiment, the pressure applied between the first and second interlayer connection portions 40 and 50, and the front and back surface patterns 21 and 31 by the pressing plates is increased. Thus, the alloy layers 71 and 72 can be formed with a lower pressure being applied to the laminate 90 from the pressing plates, than in the first embodiment.

After that, the resultant object is cooled until time point T2, while the pressure of 5 MPa being retained. As a result, an integral body of the laminate 90 can be obtained to thereby produce the thermoelectric converter 1.

In the present embodiment, at the step shown in Fig. 12 by (b), the first and second interlayer connection members 40 and 50 are embedded in the first and second via holes 11 and 12, respectively. Accordingly, there is no need of providing a step of evaporating the organic solvents as in the first embodiment (the interval between T0 to T1 in Fig. 6).

As described above, the thermoelectric converter 1 is ensured to be produced by embedding the first and second interlayer connection members 40 and 50 in the first and second via holes 11 and 12, respectively. With this way of production as well, the alloy layers 71 and 72 can be formed to thereby achieve the advantageous effects similar to those of the first embodiment.

As described above, the first and second interlayer connection members 40 and 50 are embedded in the first and second via holes 11 and 12, respectively, formed in the insulating base 10. At the step of integration, such an insulating base 10 can cancel the stress components in a direction perpendicular to the lamination direction, from among the stress components generated in the first and second interlayer connection members 40 and 50. Accordingly, the first and second interlayer connection members 40 and 50 can be prevented from being cracked in a direction perpendicular to the lamination direction.

### (Other Embodiments)

The present invention should not be construed as being limited to the foregoing embodiments, but may be appropriately modified within a scope of the claims.

For example, the first to fourth embodiments described above include a step of preparing the insulating base 10 which is filled with the first and second conductive pastes 41 and 51. At this step, the first and second via holes 11 and 12 may be concurrently formed in preparing the insulating base 10. In this case, a mask having openings with areas corresponding to the first via holes 11 may be located on the front surface 10a of the insulating base 10 to fill only the first via holes 11 with the first conductive past 41, followed by filling the second conductive paste 51 at normal temperature.

Alternatively, after filling the first via holes 11 with the first conductive paste 41, a mask having openings with areas corresponding to the second via holes 12 may be located on the front surface 10a of the insulating base 10. In this case, in filling the second via holes 12 with the second conductive paste 51, the mask is able prevent the second conductive paste 51 from entering the first via holes 11. Accordingly, the organic solvent configuring the second conductive paste 51 that can be used can include ones that may melt the first conductive paste 41, in filling the second conductive paste 51. For example, paraffin that is also used as the organic solvent of the first conductive paste 41 can be used. In this case, terpene may also be used, as a matter of course, as an organic solvent of the first and second conductive pastes 41 and 51.

Further, after performing the step shown in Fig. 5 by (b) in the first embodiment, the first and second conductive pastes 41 and 51 may be sintered in advance to form the first and second interlayer connection members 40 and 50, respectively. Then, using the insulating base 10 arranged with the first and second interlayer connection members 40 and 50, the thermoelectric converter 1 may be configured as in the fifth embodiment.

In the foregoing embodiments, the second interlayer connection member 50 may be configured by metal particles such as of an Ag-Sn based alloy or the like. In other words, as the second interlayer connection member 50, a material for mainly enhancing conduction may be used instead of a material mainly having a thermoelectric effect. In this case, the positions for forming the first and second via holes 11 and 12 may be appropriately changed, while appropriately changing the shapes of the front and back surface patterns 21 and 31. For example, the first interlayer connection members 40 arranged along the long-side direction of the insulating member 10 may be parallelly connected via the respective second interlayer connection members 50.

Further, the heating temperature, the applied pressure and the processing time in performing the step shown in Fig. 5 by (h) or Fig. 12 by (f) in the foregoing embodiments are only examples. By appropriately changing these conditions, the thickness of the alloy layers 71 and 72 can be changed. Preferably, these conditions are appropriately changed to obtain the alloy layers 71 and 72 having a thickness suitable for the usage.

The foregoing embodiments may be appropriately combined. For example, the second embodiment may be combined with the third to fifth embodiments to thereby provide the plating film 21b to the front surface pattern 21 and at the same time provide the plating film 31b to the back surface pattern 31. Also, by combining the third embodiment with the fourth and fifth embodiments, the through holes 13 may be formed in the insulating base 10 in producing the thermoelectric converter 1. Further, by combining the fourth embodiment with the fifth embodiment, the pair of pressing plates 100 formed with the recesses 100a may be used to obtain an integral body of the laminate 90. In addition, combinations of the foregoing embodiments may further be appropriately combined with other embodiments.

The air spaces in the foregoing third embodiment do not have to be the through holes 13. For example, as the air spaces, frame-shaped grooves may be formed on either of the front and back surfaces 10a and 10b of the insulating base 10 to enclose the first and second via holes 11 and 12. Further, the insulating base 10 may include glass cloth having voids therein as the air spaces. Alternatively, the insulating base 10 may be of a porous material, with a plurality of pores being formed therein as the air spaces.

The thermoelectric effect is caused if only two different metals are connected. Accordingly, in the foregoing embodiments, the insulating base 10 may be formed with only the first via holes 11, with only the first interlayer connection members 40 being arranged in the respective first via holes 11. In other words, the present invention can be applied to a thermoelectric converter in which only one type of interlayer connection members are arranged in the insulating base 10.

### [Reference Signs List]

- 10: Insulating base
- 11: First via hole
- 12: Second via hole
- 21: Front surface pattern
- 31: Back surface pattern
- 40: First interlayer connection member (thermoelectric element)
- 50: Second interlayer connection member (thermoelectric element)
- 71: Alloy layer
- 72: Alloy layer

## Claims

1. A thermoelectric converter comprising:
an insulating base (10) that is formed with a plurality of via holes (11 and 12) therethrough in a thickness direction;
thermoelectric elements (40 and 50) that are arranged at the via holes and formed of an alloy in which a plurality of metal atoms retain a predetermined crystal structure;
front surface patterns (21) that are arranged on a front surface (10a) of the insulating base and are each electrically connected to predetermined ones of the thermoelectric elements; and
back surface patterns (31) that are arranged on a back surface (10b) of the insulating base and are each electrically connected to predetermined ones of the thermoelectric elements, **characterized in that**:
each of the thermoelectric elements and each of the front surface patterns have an interface therebetween in which metal atoms configuring the thermoelectric elements and metal atoms configuring the front surface are diffused to configure an alloy layer (71);
each of the thermoelectric elements and each of the back surface patterns have an interface therebetween in which metal atoms configuring the thermoelectric elements and metal atoms configuring the back surface patterns are diffused to configure an alloy layer (72); and
the respective thermoelectric elements, the front surface patterns and the respective back surface patterns are electrically and mechanically connected to each other via the alloy layers.

2. The thermoelectric converter according to claim 1, **characterized in that** the thermoelectric elements include thermoelectric elements which are configured to contain an alloy of a Bi-Sb-Te based alloy.

3. The thermoelectric converter according to claim 1 or 2, **characterized in that** the thermoelectric elements include thermoelectric elements which are configured to contain an alloy of a Bi-Te based alloy.

4. The thermoelectric converter according to any one of claims 1 to 3, **characterized in that** the front surface patterns and the back surface patterns are configured to contain Cu.

5. The thermoelectric converter according to any one of claims 1 to 4, **characterized in that** the alloy layers are configured to contain a Cu-Te based alloy or a Cu-Bi based alloy.

6. The thermoelectric converter according to any one of claims 1 to 5, **characterized in that**:
the front surface patterns and the back surface patterns are formed of ground wirings (21a and 31a) and plating films (21b and 31b) formed on the ground wirings; and
the alloy layers are formed as a result of diffusion of metal atoms configuring the thermoelectric elements and metal atoms configuring the plating films.

7. The thermoelectric converter according to claim 6, **characterized in that** the plating films are configured by Ni.

8. The thermoelectric converter according to claim 6 or 7, **characterized in that** the alloy layers are configured to contain a Ni-Te based alloy or a Ni-Bi based alloy.

9. A method for producing a thermoelectric converter **characterized in that** the method comprises:
a step of preparing an insulating base (10) that is configured to contain a thermoplastic resin, and formed with a plurality of via holes (11 and 12) therethrough in a thickness direction, the via holes being filled with conductive pastes (41 and 51) that are each in paste form with an addition of an organic solvent to an alloy powder in which a plurality of metal atoms retain a predetermined crystal structure;
a step of forming a laminate (90) by arranging a front surface protective member (20) on a front surface (10a) of the insulating base, the front surface protective member (20) having front surface patterns (21) each contacting predetermined ones of the conductive pastes, and by arranging a back surface protective member (30) on a back surface (10b) of the insulating base, the back surface protective member (30) having back surface patterns (31) each contacting predetermined ones of the conductive pastes; and
a step of integration that is performed by:
applying pressure to the laminate in a lamination direction, while the laminate is heated;
while forming thermoelectric elements (40 and 50) from the conductive pastes, forming an alloy layer (71) by diffusion of metal atoms configuring the thermoelectric elements and metal atoms configuring the front surface patterns, and forming an alloy layer (72) by diffusion of metal atoms configuring the thermoelectric elements and metal atoms configuring the back surface patterns; and
electrically and mechanically connecting the respective thermoelectric elements, the respective front surface patterns and the respective back surface patterns to each other via the alloy layers.

10. The method for producing a thermoelectric converter according to claim 9, **characterized in that** the step of integration includes: a step of heating the laminate to evaporate the organic solvent contained in each of the conductive pastes; a step of applying pressure to the laminate from the lamination direction while the laminate is heated to a temperature equal to or more than a softening point of the thermoplastic resin that configures the insulating base, and electrically and mechanically connecting the respective thermoelectric elements, the respective front surface patterns and the respective back surface patterns to each other via the alloy layers; and a step of obtaining an integral body of the laminate by cooling the laminate, while application of the pressure being kept from the lamination direction.

11. The method for producing a thermoelectric converter according to claim 9 or 10, **characterized in that**, at the step of preparing the insulating base, some of the plurality of via holes are prepared as ones filled with the conductive paste of a metal powder that contains a Bi-Sb-Te based alloy.

12. The method for producing a thermoelectric converter according to any one of claims 9 to 11, **characterized in that**, at the step of preparing the insulating base, some of the plurality of via holes are prepared as ones filled with the conductive paste of a metal powder that contains a Bi-Te based alloy.

13. A method for producing a thermoelectric converter, **characterized in that** the method comprises:
a step of preparing an insulating base (10) that is configured to contain a thermoplastic resin, formed with a plurality of via holes (11 and 12) therethrough in a thickness direction, and embedded with thermoelectric elements (40 and 50) in the via holes;
a step of forming a laminate (90) by arranging a front surface protective member (20) on a front surface (10a) of the insulating base, the front surface protective member (20) having front surface patterns (21) each contacting predetermined ones of the thermoelectric elements, and by arranging a back surface protective member (30) on a back surface (10b) of the insulating base, the back surface protective member (30) having back surface patterns (31) each contacting predetermined ones of the thermoelectric elements; and
a step of integration performed by applying pressure to the laminate in a lamination direction while the laminate is heated, forming an alloy layer (71) that is configured by diffusion of metal atoms configuring the thermoelectric elements and metal atoms configuring the front surface patterns, while forming an alloy layer (72) by diffusion of metal atoms configuring the thermoelectric elements and metal atoms configuring the back surface patterns, and electrically and mechanically connecting the respective thermoelectric elements, the respective front surface patterns and the respective back surface patterns to each other via the alloy layers.

14. The method for producing a thermoelectric converter according to claim 13, **characterized in that** the step of integration includes: a step of applying pressure to the laminate from the lamination direction while the laminate is heated to a temperature equal to or more than a softening point of the thermoplastic resin that configures the insulating base, and electrically and mechanically connecting the respective thermoelectric elements, the respective front surface patterns and the respective back surface patterns to each other via the alloy layers; and a step of obtaining an integral body of the laminate by cooling the laminate, while application of the pressure is kept from the lamination direction.

15. The method for producing a thermoelectric converter according to claim 13 or 14, **characterized in that**, at the step of preparing the insulating base, members embedded with a material that contains a Bi-Sb-Te based alloy are prepared as some of the thermoelectric elements.

16. The method for producing a thermoelectric converter according to any one of claims 13 to 15, **characterized in that**, at the step of preparing the insulating base, members embedded with a material that contains a Bi-Te based alloy are prepared as some of the thermoelectric elements.

17. The method for producing a thermoelectric converter according to any one of claims 9 to 16, **characterized in that**, at the step of forming the laminate, the front surface protective member in use includes the front surface patterns configured by Cu, and the back surface protective member in use includes the back surface patterns configured by Cu.

18. The method for producing a thermoelectric converter according to any one of claims 9 to 17, **characterized in that**, at the step of integration, layers that contain a Cu-Te based alloy or a Cu-Bi based alloy are formed as the alloy layers.

19. The method for producing a thermoelectric converter according to any one of claims 9 to 18, **characterized in that**:
prior to the step of forming the laminate, the insulating base is formed with air spaces (13); and
at the step of integration, the thermoelectric elements and the alloy layers are formed, while the thermoplastic resin is fluidized and flowed into the air spaces.

20. The method for producing a thermoelectric converter according to any one of claims 9 to 19, **characterized in that**:
at the step of forming the laminate, members that contain a thermoplastic resin are used as the front surface protective member and the back surface protective member; and
at the step of integration, the laminate is applied with pressure using a pair of pressing plates (100) that are formed with recesses (100a) in at least either of those portions which face a front surface of the insulating base and those portions which face a back surface of the insulating base, at least one of thermoplastic resins configuring the front surface protective member and the back surface protective member is fluidized and flowed into the recesses, and the thermoelectric elements and the alloy layers are formed while the thermoplastic resin configuring the insulating base is fluidized.

## Amended claims

### Amended claims under Art. 19.1 PCT

**1.** A thermoelectric converter comprising:
an insulating base (10) that is formed with a plurality of via holes (11 and 12) therethrough in a thickness direction;
thermoelectric elements (40 and 50) that are arranged at the via holes and formed of an alloy in which a plurality of metal atoms retain a predetermined crystal structure;
front surface patterns (21) that are arranged on a front surface (10a) of the insulating base and are each electrically connected to predetermined ones of the thermoelectric elements; and
back surface patterns (31) that are arranged on a back surface (10b) of the insulating base and are each electrically connected to predetermined ones of the thermoelectric elements, **characterized in that**:
each of the thermoelectric elements and each of the front surface patterns have an interface therebetween in which metal atoms configuring the thermoelectric elements and metal atoms configuring the front surface patterns are diffused by solid-phase sintering to configure an alloy layer (71);
each of the thermoelectric elements and each of the back surface patterns have an interface therebetween in which metal atoms configuring the thermoelectric elements and metal atoms configuring the back surface patterns are diffused to configure an alloy layer (72); and
the respective thermoelectric elements, the respective front surface patterns and the respective back surface patterns are electrically and mechanically connected to each other via the alloy layers.

**2.** The thermoelectric converter according to claim 1, **characterized in that** the thermoelectric elements include thermoelectric elements which are configured to contain a Bi-Sb-Te based alloy.

**3.** The thermoelectric converter according to claim 1 or 2, **characterized in that** the thermoelectric elements include thermoelectric elements which are configured to contain a Bi-Te based alloy.

**4.** The thermoelectric converter according to any one of claims 1 to 3, **characterized in that** the front surface patterns and the back surface patterns are configured to contain Cu.

**5.** The thermoelectric converter according to any one of claims 1 to 4, **characterized in that** the alloy layers are configured to contain a Cu-Te based alloy or a Cu-Bi based alloy.

**6.** The thermoelectric converter according to any one of claims 1 to 5, **characterized in that**:
the front surface patterns and the back surface patterns are formed of ground wirings (21a and 31a) and plating films (21b and 31b) formed on the ground wirings; and
the alloy layers are formed as a result of diffusion of metal atoms configuring the thermoelectric elements and metal atoms configuring the plating films.

**7.** The thermoelectric converter according to claim 6, **characterized in that** the plating films are configured by Ni.

**8.** The thermoelectric converter according to claim 6 or 7, **characterized in that** the alloy layers are configured to contain a Ni-Te based alloy or a Ni-Bi based alloy.

**9.** (Amended) A method for producing a thermoelectric converter **characterized in that** the method comprises:
a step of preparing an insulating base (10) that is configured to contain a thermoplastic resin, and formed with a plurality of via holes (11 and 12) therethrough in a thickness direction, the via holes being filled with conductive pastes (41 and 51) that are each in paste form with an addition of an organic solvent to an alloy powder in which a plurality of metal atoms retain a predetermined crystal structure;
a step of forming a laminate (90) by arranging a front surface protective member (20) on a front surface (10a) of the insulating base, the front surface protective member (20) having front surface patterns (21) each contacting predetermined ones of the conductive pastes, and by arranging a back surface protective member (30) on a back surface (10b) of the insulating base, the back surface protective member (30) having back surface patterns (31) each contacting predetermined ones of the conductive pastes; and
a step of integration that is performed by:
applying a pressure to the laminate in a lamination direction, while the laminate is heated;
while forming thermoelectric elements (40 and 50) from the conductive pastes, forming an alloy layer (71) by diffusion of metal atoms configuring the thermoelectric elements and metal atoms configuring the front surface patterns, and forming an alloy layer (72) by diffusion of metal atoms configuring the thermoelectric elements and metal atoms configuring the back surface patterns; and
electrically and mechanically connecting the respective thermoelectric elements, the respective front surface patterns and the respective back surface patterns to each other via the alloy layers, and in the method,
the step of integration including: a step of heating the laminate to evaporate the organic solvent contained in each of the conductive pastes; a step of applying a pressure to the laminate from the lamination direction while the laminate is heated to a temperature equal to or more than a softening point of the thermoplastic resin that configures the insulating base, and electrically and mechanically connecting the respective thermoelectric elements, the respective front surface patterns and the respective back surface patterns to each other via the alloy layers; and a step of obtaining an integral body of the laminate by cooling the laminate, while application of the pressure being kept from the lamination direction.

**10.** Deleted)

**11.** (Amended) The method for producing a thermoelectric converter according to claim 9, **characterized in that**, at the step of preparing the insulating base, some of the plurality of via holes are prepared as ones filled with the conductive paste of a metal powder that contains a Bi-Sb-Te based alloy.

**12.** (Amended) The method for producing a thermoelectric converter according to claim 9, **characterized in that**, at the step of preparing the insulating base, some of the plurality of via holes are prepared as ones filled with the conductive paste of a metal powder that contains a Bi-Te based alloy.

**13.** (Amended) A method for producing a thermoelectric converter, **characterized in that** the method comprises:
a step of preparing an insulating base (10) that is that is configured to contain a thermoplastic resin, formed with a plurality of via holes (11 and 12) therethrough in a thickness direction, and embedded with thermoelectric elements (40 and 50) in the via holes;
a step of forming a laminated (90) by arranging a front surface protective member (20) on a front surface (10a) of the insulating base, the front surface protective member (20) having front surface patterns (21) each contacting predetermined ones of the thermoelectric elements, and by arranging a back surface protective member (30) on a back surface (10b) of the insulating base, the back surface protective member (30) having back surface patterns (31) each contacting predetermined ones of the thermoelectric elements; and
a step of integration performed by applying a pressure to the laminate in a lamination direction while the laminate is heated, forming an alloy layer (71) that is configured by diffusion of metal atoms configuring the thermoelectric elements and metal atoms configuring the front surface patterns, while forming an alloy layer (72) by diffusion of metal atoms configuring the thermoelectric elements and metal atoms configuring the back surface patterns, and electrically and mechanically connecting the respective thermoelectric elements, the respective front surface patterns and the respective back surface patterns to each other via the alloy layers, and in the method,
the step of integration includes: a step of applying a pressure to the laminate from the lamination direction while the laminate is heated to a temperature equal to or more than a softening point of the thermoplastic resin that configures the insulating base, and electrically and mechanically connecting the respective thermoelectric elements, the respective front surface patterns and the respective back surface patterns to each other via the alloy layers; and a step of obtaining an integral body of the laminate by cooling the laminate, while application of the pressure is kept from the lamination direction.

**14.** Deleted)

**15.** (Amended) The method for producing a thermoelectric converter according to claim 13, **characterized in that**, at the step of preparing the insulating base, members embedded with a material that contains a Bi-Sb-Te based alloy are prepared as some of the thermoelectric elements.

**16.** (Amended) The method for producing a thermoelectric converter according to claim 13, **characterized in that**, at the step of preparing the insulating base, members embedded with a material that contains a Bi-Te based alloy are prepared as some of the thermoelectric elements.

**17.** (Amended) The method for producing a thermoelectric converter according to claim 9 or 13, **characterized in that**, at the step of forming the laminate, the front surface protective member in use includes the front surface patterns configured by Cu, and the back surface protective member in use includes the back surface patterns configured by Cu.

**18.** (Amended) The method for producing a thermoelectric converter according to claim 9 to 13, **characterized in that**, at the step of integration, layers that contain a Cu-Te based alloy or a Cu-Bi based alloy are formed as the alloy layers.

**19.** (Amended) A method for producing a thermoelectric converter **characterized in that** the method comprises:
a step of preparing an insulating base (10) that is configured to contain a thermoplastic resin, and formed with a plurality of via holes (11 and 12) therethrough in a thickness direction, the via holes being filled with conductive pastes (41 and 51) that are each in paste form with an addition of an organic solvent to an alloy powder in which a plurality of metal atoms retain a predetermined crystal structure;
a step of forming a laminate (90) by arranging a front surface protective member (20) on a front surface (10a) of the insulating base, the front surface protective member (20) having front surface patterns (21) each contacting predetermined ones of the conductive pastes, and by arranging a back surface protective member (30) on a back surface (10b) of the insulating base, the back surface protective member (30) having back surface patterns (31) each contacting predetermined ones of the conductive pastes; and
a step of integration that is performed by:
applying a pressure to the laminate in a lamination direction, while the laminate is heated;
while forming thermoelectric elements (40 and 50) from the conductive pastes, forming an alloy layer (71) by diffusing metal atoms configuring the thermoelectric elements and metal atoms configuring the front surface patterns, and forming an alloy layer (72) by diffusing metal atoms configuring the thermoelectric elements and metal atoms configuring the back surface patterns; and
electrically and mechanically connecting the respective thermoelectric elements, the respective front surface patterns and the respective back surface patterns to each other via the alloy layers, and in the method,
prior to the step of forming the laminate, the insulating base is formed with air spaces (13); and
at the step of integration, the thermoelectric elements and the alloy layers are formed, while the thermoplastic resin is fluidized and flowed into the air spaces.

**20.** (Amended) A method for producing a thermoelectric converter **characterized in that** the method comprises:
a step of preparing an insulating base (10) that is configured to contain a thermoplastic resin, and formed with a plurality of via holes (11 and 12) therethrough in a thickness direction, the via holes being filled with conductive pastes (41 and 51) that are each in paste form with an addition of an organic solvent to an alloy powder in which a plurality of metal atoms retain a predetermined crystal structure;
a step of forming a laminate (90) by arranging a front surface protective member (20) on a front surface (10a) of the insulating base, the front surface protective member (20) having front surface patterns (21) each contacting predetermined ones of the conductive pastes, and by arranging a back surface protective member (30) on a back surface (10b) of the insulating base, the back surface protective member (30) having back surface patterns (31) each contacting predetermined ones of the conductive pastes; and
a step of integration that is performed by:
applying a pressure to the laminated in a lamination direction, while the laminate is heated;
while forming thermoelectric elements (40 and 50) from the conductive pastes, forming an alloy layer (71) by diffusing metal atoms configuring the thermoelectric elements and metal atoms configuring the front surface patterns, and forming an alloy layer (72) by diffusing metal atoms configuring the thermoelectric elements and metal atoms configuring the back surface patterns; and
electrically and mechanically connecting the respective thermoelectric elements, the respective front surface patterns and the respective back surface patterns to each other via the alloy layers, and in the method,
at the step of forming the laminate, members that contain a thermoplastic resin are used as the front surface protective member and the back surface protective member; and
at the step of integration, the laminate is applied with a pressure using a pair of pressing plates (100) that are formed with recesses (100a) in at least one of a portion facing a front surface of the insulating base and a portion facing a back surface of the insulating base, at least one of thermoplastic resins configuring the front surface protective member and the back surface protective member is fluidized into the recesses, and the thermoelectric elements and the alloy layers are formed while the thermoplastic resin configuring the insulating base is fluidized.

**21.** New) A method for producing a thermoelectric converter, **characterized in that** the method comprises:
a step of preparing an insulating base (10) that is configured to contain a thermoplastic resin, and provided with the via holes in which thermoelectric elements (40 and 50) are embedded;
a step of forming a laminate (90) by arranging a front surface protective member (20) on a front surface (10a) of the insulating base, the front surface protective member (20) having front surface patterns (21) each contacting predetermined ones of the thermoelectric elements, and by arranging a back surface protective member (30) on a back surface (10b) of the insulating base, the back surface protective member (30) having back surface patterns (31) each contacting predetermined ones of the thermoelectric elements; and
forming an alloy layer (71) by diffusing metal atoms configuring the thermoelectric elements and metal atoms configuring the front surface patterns, and forming an alloy layer (72) by diffusing metal atoms configuring the thermoelectric elements and metal atoms configuring the back surface patterns; and electrically and mechanically connecting the respective thermoelectric elements, the respective front surface patterns and the respective back surface patterns to each other via the alloy layers, and in the method,
prior to the step of forming the laminate, the insulating base is formed with air spaces (13); and
at the step of integration, the thermoelectric elements and the alloy layers are formed, while the thermoplastic resin is fluidized into the air spaces.

**22.** New) A method for producing a thermoelectric converter, **characterized in that** the method comprises:
a step of preparing an insulating base (10) that is configured to contain a thermoplastic resin, and provided with the via holes in which thermoelectric elements (40 and 50) are embedded;
a step of forming a laminated (90) by arranging a front surface protective member (20) on a front surface (10a) of the insulating base, the front surface protective member (20) having front surface patterns (21) each contacting predetermined ones of the thermoelectric elements, and by arranging a back surface protective member (30) on a back surface (10b) of the insulating base, the back surface protective member (30) having back surface patterns (31) each contacting predetermined ones of the thermoelectric elements; and
forming an alloy layer (71) by diffusing metal atoms configuring the thermoelectric elements and metal atoms configuring the front surface patterns, and forming an alloy layer (72) by diffusing metal atoms configuring the thermoelectric elements and metal atoms configuring the back surface patterns; and electrically and mechanically connecting the respective thermoelectric elements, the respective front surface patterns and the respective back surface patterns to each other via the alloy layers, and in the method,
at the step of forming the laminate, members that contain a thermoplastic resin are used as the front surface protective member and the back surface protective member; and
at the step of integration, the laminate is applied with a pressure using a pair of pressing plates (100) that are formed with recesses (100a) in at least either of those portions which face a front surface of the insulating base and those portions which face a back surface of the insulating base, at least one of thermoplastic resins configuring the front surface protective member and the back surface protective member is fluidized and flowed into the recesses, and the thermoelectric elements and the alloy layers are formed while the thermoplastic resin configuring the insulating base is fluidized.

Statement under Art. 19.1 PCT
In the thermoelectric converter related to claim 1, it has been made clear that the alloy layer formed in the interface between each of the thermoelectric elements and each of the front surface patterns is configured by diffusing the metal atoms configuring the thermoelectric elements and the metal atoms configuring the front surface patterns by having the metal atoms solid-phase sintered.

The matter that "the alloy layers are formed by solid-phase sintering" is neither taught nor suggested by PTSs 1, 2 and 3.

In accordance with the Opinion of the International Searching Authority, the claims have been amended as follows.

Claims 9 and 10 have been combined as an independent claim 9. Accordingly, claim 10 has been deleted, while claims 11 and 12 have been made dependent from claim 9.

Similarly, claims 13 and 14 have been combined as an independent claim 13. Accordingly, claim 14 has been deleted, while claims 15 and 16 have been made dependent from claim 13.

On the other hand, dependency of claims 17 and 18 has been changed to "claim 9 or 13".

Further, claims 9 and 19 have been combined and changed to an independent claim 19. Claims 9 and 20 have been combined and changed to independent claim 20.

Furthermore, contents of claim 19 have been added to claim 13 to create a new independent claim 21. Similarly, contents of claim 20 have been added to claim 13 to create a new independent claim 22.
